# EUROPEAN PATENT APPLICATION

(11) **EP 0 665 469 A2**
(43) Date of publication of application: **02.08.1995**
(21) Application number: 95400168.1
(22) Date of filing: 26.01.1995
(51) Int. Cl.: G03F 7/11, B41N 3/03, G03F 7/20

(54) **Multilayer flexographic printing plate**

(30) Priority: 28.01.1994 US 188450
(71) Applicant: MINNESOTA MINING AND MANUFACTURING COMPANY, St. Paul, Minnesota 55133-3427 (US)
(72) Inventor: Wang, Paul J., Minnesota Mining & Manuf. Co.,, Saint Paul, Minnesota 55133-3427 (US); Martens, John A., Minnesota Mining & Manuf. Co.,, Saint Paul, Minnesota 55133-3427 (US); Staus, Gary A., Minnesota Mining & Manuf. Co.,, Saint Paul, Minnesota 55133-3427 (US)
(74) Representative: Warcoin, Jacques

(57) **Abstract**

This invention provides a process for producing a multilayer, flexible photosensitive plate comprising (i) applying a first photosensitive elastomeric layer to a flexible substrate, (ii) curing the first photosensitive elastomeric layer by exposure to actinic radiation, and (iii) following this curing, applying a second layer, which is at least 0.2 mm thick, onto the first photosensitive layer, the second layer comprising a photosensitive elastomeric composition having no more than 1% by weight ethylenically unsaturated copolymerizable molecules with molecular weights less than 500. This multilayer photosensitive plate may be used as a flexographic printing plate if imagewise exposed and developed. These multilayer plates are particularly suitable for thermal development.

## Description

### Background

### 1. Field of the Invention

The present invention relates to multilayer flexographic printing plates.

### 2. Background of the Invention

Flexography is a term broadly applicable to a printing format that uses a flexible substrate bearing an elastomeric or rubbery relief printing surface. The first flexographic printing plates were produced from natural or synthetic rubber compositions which were cured chemically under heat and pressure in a mold utilizing conventional rubber curatives such as mercapto compounds (*Flexography: Principles and Practices*, 3rd Edition, Flexographic Technical Association, p. 158-162). More recently, photopolymer elastomeric compositions (elastomer containing compositions curable upon exposure to actinic radiation) have been used to produce relief printing plates. For example, U.S. Patent 4,162,919 describes the use of a photosensitive composition containing a block copolymer as an elastomeric polymeric binder, a compatible ethylenically unsaturated monomer, and a photoinitiator. Similarly, British Patent 1,454,191 describes the use of an elastomeric polyurethane based photosensitive layer. In both cases, the standard solvent wash procedure is used to develop the relief layer after exposure to actinic radiation. European Patent 261,910 describes an aqueous-developable flexographic printing plate.

U.S. Patents 3,948,665 and 4,162,919 and British Patent 1,454,191 describe flexographic plates which, in addition to the relief layer and the substrate, contain an elastomeric layer for purposes of adjusting hardness. All three patents relate to solvent wash developable systems.

Both the solvent wash and aqueous wash developing systems are time consuming since drying for extended periods (1 to 24 hours) is necessary to remove entrained developer solution. In addition, these developing systems produce potentially toxic by-product wastes (both the solvent and any material carried off by the solvent, such as unreacted ethylenically unsaturated monomer) during the development process.

To avoid these problems, a thermal development process may be used. In a thermal development process, the photosensitive layer, which has been image-wise exposed to actinic radiation, is contacted with an absorbent layer at a temperature sufficient to cause the composition in the unexposed portions of the photosensitive layer to soften or melt and flow into the absorbent material. See U.S. Patent No. 3,264,103 for planographic development and U.S. Patent No. 5,015,556 for relief development. One drawback to this process is the emission of volatiles (such as unreacted monomer) during thermal development.

An additional processing step that is frequently used in producing flexographic printing plates is irradiating the photosensitive, elastomeric layer of the plate with ultraviolet radiation or e-beams through the flexible substrate. This process is described in U.S. Patents No. 5,215,859, 4,264,705, 5,015,556, and 4,927,723. The photosensitive layer is thereby partially cured forming a "floor" which is not removed during development.

Unfortunately, neither ultraviolet nor e-beam radiation through the substrate is entirely satisfactory for flexographic printing plates produced by thermal development. Ultraviolet backflashing is problematic because it is difficult to control the extent and depth of cure. A back flash that is of too short a duration provides an insufficient anchor for the relief image, and the resulting image may break off from the base of the printing plate. On the other hand, if the backflash is maintained too long, the top of the photosensitive layer begins to cure and becomes too viscous to be developed thermally. Slight overcuring is not a serious detriment in solvent or aqueous developing systems because generally the solvent or aqueous solution is brushed on and that brushing smooths the surface and helps remove particles still adhering to the imaged plate. However, in thermally developed systems, it has been found that UV backflashing does not allow for good clean-out of the nonirradiated areas of the printing plate.

The use of electron beam irradiation to set the floor provides more consistent results as compared to UV radiation. The penetration of the electron beam into the plate can be precisely controlled by selection of the proper accelerating voltage of the electrons. The use of electron beam is suffested when relatively thin (<1.2 mm) flexographic printing plates are desired. However, electron beams are impractical for producing adequate floors for the frequently desired thicker plates (> 1.2 mm) due to the inordinately high accelerating voltages required (>300 KeV) to achieve adequate penetration depth into the plate.

### Summary of the Invention

This invention provides a multilayer flexible plate suitable for use as a thermally developable flexographic printing plate and a process for making that plate.

According to one embodiment, this invention provides a process for producing a multilayer, flexible photosensitive plate comprising (i) applying a first photosensitive elastomeric layer to a flexible substrate, (ii) curing the first photosensitive elastomeric layer by exposure to actinic radiation, and (iii) following this curing, applying a second layer, which is at least 0.2 mm thick, onto the first photosensitive layer, the second layer comprising a photosensitive elastomeric composition having no more than 1% by weight ethylenically unsaturated copolymerizable molecules with molecular weights less than 500.

In a second embodiment, the invention is a multilayered, flexible photosensitive plate comprising
A) a flexible substrate,
B) a first photosensitive elastomer layer which has been cured by exposure to radiation, and
C) a second photosensitive elastomeric layer at least 0.2 mm thick having no more than 1% by weight ethylenically unsaturated copolymerizable molecules with molecular weights less than 500.

In yet another embodiment, the invention provides a process for producing a multilayered flexographic printing plate comprising:
(i) applying a first photosensitive, elastomeric layer to a flexible substrate,
(ii) curing the elastomeric composition by exposure to radiation,
(iii) applying a second layer at least 0.2 mm thick onto the first elastomer layer, the second layer comprising a photosensitive curable elastomer composition having no more than 1% by weight ethylenically unsaturated copolymerizable molecules with molecular weights less than 500,
(iv) image-wise exposing the second photosensitive, elastomeric layer to ultraviolet radiation, and
(v) developing the printing plate by contacting the image-wise exposed photosensitive elastomeric layer with an absorbent material at a temperature sufficient to enable unexposed portions of the photosensitive layer to flow into the absorbent layer.

The invention is also embodied by a flexographic printing plate made according to this procedure. The flexographic printing plate comprises a substrate, a floor layer in which the degree of cure is constant in a plane parallel to the substrate, and an image bearing relief layer. The flexographic printing plates of this invention have a well defined image and good clean out of non-irradiated areas.

### Detailed Description of the Invention

The process of the present invention comprises applying a first layer of a photosensitive, elastomeric composition onto a flexible substrate, curing the elastomeric composition by exposure to actinic radiation, and, following the curing of the first layer, applying a second photosensitive elastomeric layer with a low content of volatiles onto the cured first layer. The compositions of the two photosensitive layers preferably may be identical. However, according to some preferred embodiments the compositions of the two photosensitive layers are at least slightly different from each other. The photosensitive elastomeric layers may be applied by any of the conventional methods for applying a film layer to a substrate, including lamination, knife coating, roller coating, extrusion, and the like.

Curing the first layer allows for a well defined image and a smooth floor following imagewise exposure and thermal development of the flexographic printing plate. Such curing of the first layer before addition of the second photosensitive layer also facilitates control of the floor thickness. Floor thickness may now be set merely by changing the thickness of the first layer. The thickness of the first layer is preferably at least 0.2 mm, more preferably in the range from about 0.5 mm to about 1.5 mm. The second layer preferably is at least 0.2 mm thick and more preferably is in the range from about 0.4 mm to about 1.5 mm thick.

The degree of cure of the first layer must be such that the layer will not be removed during thermal development. Thus, the first layer may be fully cured or cross-linked. However, it may be desirable that the first layer is not completely cross-linked during cure, since adhesion between the first and second layers will be improved if the first layer was not fully crosslinked until after application of the relief forming layer.

The low content of volatiles in the second photosensitive layer is desirable to reduce emissions of these volatiles during thermal development. The second photosensitive layer preferably contains less than 1.0%, more preferably less than 0.5%, and most preferably less than 0.1% by weight ethylenically unsaturated copolymerizable molecules with molecular weights under 500. Limiting the amount of other materials which may volatilize during thermal development is also advisable. Many photoinitiators can be found which will not volatilize during thermal development, and such compounds are preferred. Similarly, many dyes or pigments can be safely employed without increasing the emission of volatiles. Inorganic additives, antioxidants, antiozonants, and the like generally will not volatilize during thermal development, but those that do should be used only in limited amounts or avoided entirely if possible.

The substrate may be any flexible material including metal sheets, plastic films, open or closed celled foams, compressible rubber, or some combination of the preceding materials. Plastics, especially polyesters such as polyethylene terephthalate (PET), are well suited for use as the flexible substrate. The substrate optionally may be surface treated for better adhesion. One example of such a surface treatment is corona treating the surface followed by use of a primer such as an aziridene functional material as disclosed for example in U.S. Application Ser. No. 08/189,075. The substrate may be 0.075 to 2 mm thick and is preferably 0.1 to 1.5 mm thick.

In one preferred embodiment, the cured, first photosensitive, elastomeric layer comprises 20 to 90, preferably 60 to 90, more preferably 75 to 85 parts by weight thermoplastic elastomeric block copolymer; 3 to 50, preferably 3 to 20, more preferably 5 to 15 parts by weight cross-linking agent; and 0.5 to 5.0, preferably 1 to 2.5 parts by weight photoinitiator. The elastomeric block copolymer is preferably an A-B-A type block copolymer, where A is a nonelastomeric block, preferably a vinyl polymer and most preferably polystyrene and B is an elastomeric block, preferably polybutadiene or polyisoprene. The nonelastomer to elastomer ratio should be in the range of 10:90 to 35:65. Styrene-isoprene-styrene block copolymers are especially preferred.

The cross-linking agent in this preferred embodiment should be an ethylenically unsaturated compound with at least one terminal ethylenic group. Suitable compounds include multi-functional acrylates and methacrylates. The following compounds are illustrative of, but not an exhaustive list of, suitable cross-linking agents: ethylene glycol diacrylate, hexanediol diacrylate, diethylene glycol diacrylate, glycerol diacrylate, trimethylol propane triacrylate, hexanediol dimethacrylate, glycerol triacrylate, trimethylolpropane triacrylate, ethylene glycol dimethacrylate, 1,3-propanediol dimethacrylate, 1,2,4-butanetriol trimethacrylate, and 1,4-butanediol diacrylate. For a more exhaustive list of suitable compounds see U.S. Patent 4,400,459. A mixture of mono-functional and multi-functional acrylates or methacrylates may be used. However, if using such a mixture, it is desirable to have an average of at least 1.3 acrylate groups per molecule of cross-linking agent. It is preferable to have an average of at least 1.7 acrylate groups per molecule of cross-linking agent, and it is most preferable to have at least 2.1 acrylate groups per molecule of cross-linking agent.

The cross-linking agent may alternatively be an ethylenically unsaturated oligomer such as a polyacryloyl oligomer. If an oligomer is used, the amount of A-B-A type block copolymer should be from 20 to 80 parts by weight and the amount of oligomer should be 15 to 50 parts by weight. The ethylenically unsaturated oligomer may be used in combination with a lower molecular weight cross-linking agent. If this combination is used, the relative amounts of the block copolymer and the cross-linking agent may have to be adjusted. Such an adjustment is important because the photosensitive composition cannot be so stiff or viscous that it is unprocessable, yet it must also not be so runny that it flows during storage.

The photoinitiator is a compound which generates free radicals upon exposure to actinic radiation. Any of the known classes of photoinitiators, particularly free radical photoinitiators such as quinones, benzophenones, benzoin ethers, aryl ketones, peroxides, biimidazoles, diaryliodoniums, triarylsulfoniums and phosphoniums, diazoniums, etc. Alternately, the photoinitiator may be a mixture of compounds, one of which provides the free radicals when caused to do so by a sensitizer activated by radiation.

Additional additives, such as colorants, processing aids, antiozonants, spectral sensitizers, and antioxidants, may be added if desired. Processing aids may be such things as low molecular weight polymers compatible with the elastomeric block copolymer, such as a low molecular weight α-methylstyrene polymer or copolymer, or fluorinated surfactants. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

In this same preferred embodiment, the second photosensitive, elastomeric layer comprises 20 to 80, preferably 40 to 60, parts by weight of a thermoplastic elastomeric block copolymer. This block copolymer may be the same as was used in the cured first layer. The second photosensitive, elastomeric layer further comprises 15 to 60, preferably 35 to 45, parts by weight of an ethylenically unsaturated oligomer. Preferably the oligomer is a polyacryloyl oligomer with a molecular weight greater than 1000, more preferably the molecular weight is greater than 2000, and most preferably the molecular weight of the oligomer is greater than 3000. The oligomer should preferably be devolatilized so that less than 500, preferably less than 300, and most preferably less than 150 parts per million of residual monomer remain. This oligomer serves as the cross linking agent for the relief layer. An oligomer is used rather than a low molecular weight compound to enable thermal development of the flexographic printing plate without emission of toxic volatiles that would be present in the unexposed regions if a lower molecular weight material is used. The ratio by weight of oligomeric acrylate crosslinking agent to elastomeric block copolymer is preferably higher than is needed if a lower molecular weight cross-linking agent is used. The higher ratio is needed to keep the viscosity of the relief plate low enough for effective thermal development. Examples of suitable oligomers include polyacryloyl rubbers such as polybutadiene acrylates and polyisoprene acrylates.

This photosensitive curable relief layer further comprises 0.5 to 5.0, preferably 1 to 2.5, parts by weight of a photosensitive free radical initiator.

As in the cured first elastomeric layer, the photosensitive curable relief layer may also contain processing aids, antiozonants, antioxidants, and the like.

In another preferred embodiment, the cured first layer comprises a photosensitive curable elastomeric polyurethane. This polyurethane is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. This first layer is cured by exposure to actinic radiation. A second photosensitive curable elastomeric polyurethane layer is then extruded onto the cured first layer. This second photosensitive layer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete discussion of these materials see U.S. Patent 5,015,556. Again processing aids, antiozonants, antioxidants and other desired additives may be used.

Frequently, a pigment layer cap is desired on top of the photosensitive curable relief layer. This pigment layer should also be a photosensitive elastomeric composition. Frequently, the binder of the pigment layer is the same as or similar to the composition of the photosensitive relief layer with the addition of a pigment.

An antistatic layer added above the relief layer or the pigment layer may be used. This antistatic layer may comprise such materials as vanadium pentoxide, quaternary ammonium compounds or other materials or layers that can be removed during thermal development.

A release layer may also be added on top of the relief layer to prevent the image bearing film used in imagewise exposing the flexographic plate from sticking to the flexographic plate. Release layers are preferably composed of polyamides or hydroxyalkyl cellulose as described in U.S. Application Ser. No. 08/189,079. In addition, a protective cover layer may be used on top of the plate. This protective layer must be easily removable, because it is removed prior to imagewise exposure of the flexographic printing plate. The cover layer or protective may be a variety of materials including plastic films (e.g., polyester) or polymer coated paper.

The process of the present invention may further comprise image-wise exposure of the photosensitive curable layer of the flexographic printing plate to actinic radiation, preferably ultraviolet radiation. The exposed plate may then be developed by contacting the exposed photosensitive layer to an absorbent surface at a temperature sufficient to cause the unexposed portions of the plate to melt and flow into the absorbent surface.

The resulting flexographic printing plate has a well defined image and good clean-out of the non-irradiated areas to leave a clean floor. A clean floor, according to the present invention, as compared to the floor produced on flexographic plates by means of backside curing from ultraviolet or e-beam radiation, is substantially smooth without visible irregularities beyond a slight, consistent texture on the floor surface. The smooth floor is believed to result because the substitution of a preliminary curing step of the first layer for the traditional backflashing method for setting the floor allows for an even or relatively constant degree of cure in planes in the first layer which are parallel to the plane of the substrate. Since the curing in these planes is generally uniform, the degree of cure of the floor layer at the interface between the floor layer and the non-irradiated portions of the second layer is more or less uniform. Cure may be measured by such techniques as gel fraction or percentage swell in a good solvent for the uncured material. For example, THF (tetrahydrofuran) is known to be a good solvent for the S-I-S block copolymer. Thus, material is more evenly removed during thermal development yielding a smoother floor.

Another unique feature of these plates which results from the two step curing procedure is that the image bearing relief layer frequently has a degree of cure at the interface with the floor layer which is different from the degree of cure of said floor layer at said interface.

### Examples

### Example 1

A roll of 7 mil (0.18 mm) polyethylene terephthalate (PET) (Layer A) was corona treated in air and coated with CX-100™, an aziridine functional compound in isopropyl alcohol from Polyvinyl Chemical. silane). A 2 mil (0.05 mm) dry adhesive layer (B) was laminated to the substrate. A 36 mil (0.91 mm) photosensitive curable elastomer composition (C) was laminated to the adhesive layer. Layer C was then exposed to ultraviolet light for 30 seconds from the top and 30 seconds from the bottom through the substrate to fully cure the photopolymer. A 36 mil (0.91 mm) photosensitive curable elastomer layer (D) was laminated to the cured polymer layer. A 4 mil (0.1 mm) polyester film (G) was laminated with a release layer (F) and a pigment layer (E). This multilayer structure was then laminated to the above structure so that layers D and E contacted each other. Layer compositions:
- A -: aziridine coated PET.
- B -: 80% (by weight) Kraton 1117™ (styreneisoprene-styrene (SIS) block copolymer from Shell Chemical Co.)
1.6% Irgacure 651™ (acetophenone photoinitiator from Ciba-Geigy)
8.4% Picotex 75™ (α-methylstyrene/vinyl toluene copolymer from Hercules)
4.0% hexanediol diacrylate
3.0% trimethylol propane triacrylate
3.0% hexanediol dimethacrylate
- C -: 65.9% Kraton 1117™
24.4% polybutadiene diacrylate Poly BD-300™ (Atochem)
1.2% Irgacure 651™
3.4% Picotex 75™
3.4% Syntene 160™ hydrocarbon wax (C&C Petroleum
1.0% antioxidant (Irganox 1076™ (Ciba-Geigy) and Cyanox LTDP™ (American Cyanamid))
- D -: 65.9% Kraton 1117™
24.4% polybutadiene diacrylate
1.2% Irgacure 651™
3.4% Picotex 75™
3.4% Syntene 160™ hydrocarbon wax
1.0% antioxidant (Irganox 1076™ and Cyanox LTDP™)
- E -: 4% pigment in a binder layer with the composition the same as layer D.
- F -: hydroxypropyl cellulose
- G -: PET

### Example 2

The multi-layer flexible plates from Example 1 were imagewise exposed and developed as follows. Layer G was removed and a negative image bearing film was placed against the release layer F. To produce reverse images on the plate, exposure to UV radiation was 3 minutes. To produce a bar code pattern, exposure to UV radiation was 9 minutes. For other patterns, exposure through a negative film occurred for 15 minutes. After exposure, the plates were developed by contact with an absorbent material at an elevated temperature. The absorbant material used was CEREX by Fiberweb America, Inc., a spunbonded nylon 6,6 non-woven material. Both the absorbent material and the image exposed plates were attached to heated transport elements. The element carrying the absorbent material was maintained at approximately 175°C, while the temperature of the element carrying the flexographic plate was at about 60°C. After 10 contacts a flexographic printing plate exhibiting a clean, smooth floor with 36 mil (0.91 mm) relief and 38 mil (0.97 mm) floor was obtained.

### Example 3

A roll of 7 mil (0.18 mm) polyethylene terephthalate (PET) (Layer A) film was corona treated in air and coated with CX-100™, an aziridine functional compound in isopropyl alcohol from Polyvinyl Chemical. The web was dried at about 100°C to give a coating thickness of several hundred angstroms. Layer B was then blended and extruded from a twin screw extruder to produce a 35 mil (0.89 mm) coating of a photosensitive composition. This photosensitive layer B was cured by exposure to UV-radiation. Subsequently, a second photosensitive composition (layer C) was extruded onto the cured layer B producing a 25 mil (0.63 mm) layer. The ingredients of layer B were in weight percent:
80.3% SIS block copolymer
10.0% ethoxylated bisphenol A diacrylate
7.4% poly(alphamethylstyrene/vinyl toluene)
0.5% antioxidant
1.3% Irgacure 651™
0.5% hydrocarbon wax

The composition of layer C in weight % was:
55.3% SIS block copolymer
35.0% polybutadiene diacrylate
7.4% poly(alphamethylstyrene/vinyl toluene)
0.5% antioxidant
1.3% Irgacure 651™
0.5% hydrocarbon wax

A 5 mil (.13 mm) polyester film (E) was coated with a 0.2% solution of vanadium pentoxide. The vanadium pentoxide solution was prepared from 0.1% vanadium pentoxide and 0.1% surfactant in de-ionized water. After drying, the coating weight was 15 mg/m². To the coated film E was added a coating (D) of a 10% polyamide solution in n-propyl alcohol and toluene. A small amount of FC170 surfactant (3M) was added to adjust adhesion. The dried coating weight of the polyamide layer D was 0.19 mg/cm². The multilayer sheet D-E was laminated to the multilayer sheet A-B-C such that layer D contacted layer C. The final multilayer structure was 67 mil (1.7 mm) thick.

### Example 4

A 7 mil (0.18 mm) polyester film (A) was corona treated and primed with CX-100™. A 28 mil (0.71 mm) curable polyurethane elastomer (B) was reaction extruded onto the primed film. This polyurethane was cured first by an electron beam through the polyester and then by top exposure to ultraviolet radiation for 30 seconds until cured. A second layer (C) of 27 mils (0.69 mm) of curable polyurethane elastomer was then laminated to layer B.

An antistatic layer (E) was coated to a 4 mil (0.1 mm) polyester film (F). An additional radiation curable pigment layer (D) was added on top of layer E. This multilayer material was then laminated to the above flexible plate so that layers D and E contacted each other.

The polyurethane layers C and D were of the same composition. To form these layers 62.5 parts by weight of a polyol stream was mixed with 37.5 parts of 4,4-bis(isocyanato cyclohexyl methane) in a twin screw extruder and extruded as a thin film. The polyol stream contained the following components (in parts by weight):
286.1 parts of 1000 MW poly 1,2-(butylene oxide) diol
32.8 parts of 1,4 butane diol
10.7 parts of 2-glycerol methacrylate
10.6 parts of Irgacure 651™ (free radical initiator)
0.1 part methylene blue
0.06 part ferric chloride
0.26 part dibutyl tin dilaurate.

The radiation curable pigmented layer D was prepared by combining the following materials in solution:
a. 300 parts of methyl ethyl ketone solution at 30% by weight solids of a methacrylate functional polyvinyl chloride copolymer;
b. 300 parts of a methyl ethyl ketone solution at 30% by weight solids of a methacrylate functional polyurethane resin containing 36% by weight hard segments consisting of 1,4-butane diol, 1-glycerol methacrylate and 4,4-bisisocyanato cyclohexyl methane;
c. 3 parts of Irgacure 369™ (Ciba-Geigy) photoinitiator;
d. 350 parts of methyl ethyl ketone solvent;
e. 50 parts of a pigment dispersion consisting of 10 parts of Sun-234™ magenta (Sun Chemical Co.) pigment, 10 parts of methacrylated PVC copolymer solution described in a. above and 30 parts of methyl ethyl ketone solvent. This dispersion was prepared by sand milling this mixture until no particles larger than 10 microns were apparent.

These materials were blended using a high speed mixer. The radiation curable pigment layer was then applied to the 4 mil (0.1 mm) polyester film in sufficient thickness so as to provide a coating which after oven drying had a weight of .54 mg/cm².

### Example 5

The flexible plate produced in Example 4 was image exposed to ultraviolet radiation through a negative image bearing film after removal of the 4 mil (0.1 mm) polyester cover layer. Exposure times were 3 minutes for reverse images and 9 minutes for all other images. Six thermal development contacts were made at process temperatures of 175°C/60°C (respectively for the elements carrying the absorbent material and the flexographic plate). The flexographic printing plate exhibited a very clean floor with 27 mil (0.69 mm) relief and 28 mil (0.71 mm) floor.

## Claims

1. A multilayered, flexible photosensitive plate comprising
A) a flexible substrate,
B) a first photosensitive elastomer layer which has been cured by exposure to radiation, and
C) a second photosensitive elastomeric layer at least 0.2 mm thick having no more than 1% by weight ethylenically unsaturated copolymerizable molecules with molecular weights less than 500.

2. The plate of claim 1 in which the first elastomer layer comprises
A) 20 to 90 parts by weight thermoplastic elastomeric ABA type block copolymer, where A is a vinyl polymer and B is an elastomer and the ratio of A:B is between 10:90 and 30:70,
B) 3 to 50 parts by weight cross-linking agent having an average of more than 1.3 acrylate groups per molecule, and
C) 0.5 to 5.0 parts by weight photoinitiator, and the uncured photosensitive layer comprises
X) 20 to 80 parts by weight thermoplastic elastomeric ABA type block copolymer,
Y) 15 to 50 parts by weight polyacryloyl crosslinking binder with a molecular weight greater than 1000, and
Z) 0.5 to 5.0 parts by weight photoinitiator.

3. The plate of claim 2 in which the polyacryloyl crosslinking binder contains less than 500 parts per million unreacted monomer.

4. The plate of claim 1 in which the first and second photosensitive layers independently comprise
A) the reaction product of
i) a diisocyanate
ii) at least one chain extending agent having at least two free hydrogen groups capable of polymerizing with isocyanate groups, and having at least one ethylenically unsaturated addition polymerizable group per molecule, and
iii) an organic polyol having a molecular weight of at least 500 and containing at least two free hydrogen containing groups capable of polymerizing with isocyanate groups per molecule, and
B) a photoinitiator.

5. A process for producing the multilayer, flexible photosensitive plate of claims 1, 2, 3, or 4 comprising (i) applying the first photosensitive elastomeric layer to the flexible substrate, (ii) curing the first photosensitive elastomeric layer by exposure to actinic radiation, and (iii) following curing of the first layer, applying the second photosensitive elastomeric layer onto the first photosensitive layer.

6. A process for producing a flexographic printing plate from the multilayer, photosensitive plate of claims 1, 2, 3, or 4 comprising:
(i) image-wise exposing the second photosensitive, elastomeric layer to ultraviolet radiation, and
(ii) developing the printing plate by contacting the image-wise exposed photosensitive elastomeric layer with an absorbent material at a temperature sufficient to enable unexposed portions of the photosensitive layer to flow into the absorbent layer.

7. A flexographic printing plate comprising a substrate, a floor layer in which the degree of cure is constant in a plane parallel to the substrate, and an image bearing relief layer.

8. The flexographic printing plate of claim 7 wherein the image bearing relief layer has a degree of cure at the interface with the floor layer which is different from the degree of cure of said floor layer at said interface.

9. The flexographic printing plate of claim 7 in which the floor layer comprises the cured product of the following reactants:
A° 20 to 90 parts by weight thermoplastic elastomeric ABA type block copolymer, where A is a vinyl polymer and B is an elastomer and the ratio of A:B is between 10:90 and 30:70,
B) 3 to 50 parts by weight cross-linking agent having an average of more than 1.3 acrylate groups per molecule, and
C)° 0.5 to 5.0 parts by weight photoinitiator, and the image bearing relief layer comprises the cured product of the following reactants:
X) 20 to 80 parts by weight thermoplastic elastomeric ABA type block copolymer,
Y) 15 to 50 parts by weight polyacryloyl crosslinking binder with a molecular weight greater than 1000, and
Z) 0.5 to 5.0 parts by weight photoinitiator.
